# EUROPÄISCHE PATENTSCHRIFT

(11) **EP 0 718 584 B1**
(45) Veröffentlichungstag und Bekanntmachung des Hinweises auf die Patenterteilung: **28.02.2001**
(21) Anmeldenummer: 95120154.0
(22) Anmeldetag: 20.12.1995
(51) Int. Cl.: F41A 27/10

(54) **Kugellafette mit Befestigungsvorrichtung**
Ball gun mount with fastening device
Affût sphérique avec dispositif de fixation

(30) Priorität: 23.12.1994 AT 240394
(43) Veröffentlichungstag der Anmeldung: 26.06.1996
(73) Patentinhaber: STEYR-DAIMLER-PUCH AKTIENGESELLSCHAFT, 1010 Wien (AT)
(72) Erfinder: Pächter, Harald, Dipl.-Ing., A-1180 Wien (AT)
(74) Vertreter: Rippel, Andreas, Dipl.-Ing.

(56) Entgegenhaltungen:
- EP-A- 0 182 124
- WO-A-90/11483
- CH-A- 473 374
- GB-A- 1 259 462

## Beschreibung

Die Erfindung handelt von einer Kugellafette für gepanzerte Fahrzeuge zur zeitweiligen Aufnahme von Handfeuerwaffen, bestehend aus einem in einer Kugelaufnahme geführten Kugelkörper und einem gegenüber diesem federnd abgestütztem Lafettenteil. Derartige Vorrichtungen finden beispielsweise in Schützenpanzern Verwendung, um den im Mannschaftsraum untergebrachten Schützen das Feuern mit dem eigenen Gewehr zu gestatten, das sie jedoch zum abgesessenen Kampf schnell aus der Lafette entfernen und mitnehmen können müssen.

Aus der EP-B 414 875 ist eine Kugellafette gemäß dem Oberbegriff des Anspruchs 1 bekannt, die aus einem ersten und einem gegenüber diesem federnd abgestützten zweiten Lafettenteil besteht. Ersterer ist fest mit dem Kugelkörper verbunden und ragt in das Innere des Kampfraumes; zweiterer ist über einen Bajonettverschluß mit dem vorderen Laufende der Handfeuerwaffe verbunden.

Nachteilig ist an dieser bekannten Vorrichtung zunächst, daß sie einer bestimmten Waffe angepaßt sein und deren Laufmündung dann auch entsprechend ausgebildet sein muß. Das bringt mit sich, daß beim Umrüsten auf eine andere Handfeuerwaffe die gesamte Kugellafette umgebaut werden muß. Weiters ist es nachteilig, daß die Lafettenteile weit in den Kampfraum hineinragen und dann erst mit der Laufmündung verbunden sind. Bei den knappen Abmessungen eines Kampfraumes bedeutet das, daß die Schützen in Raummitte stehen müssen und auch größere Richtwege haben, sie einander also behindern.

Aus der EP 182 124 A2 ist weiters eine Kugellafette bekannt, die gegenüber dem Kugelkörper nicht federnd abgestützt ist. Die Waffenaufnahme ist mit dem Handschutz der Waffe verbunden und ragt dadurch weit in den Kampfraum hinein. Sie weist aber eine Arretierung auf, durch deren Lösen die Waffe abgenommen werden kann.

Die Erfindung setzt sich das Ziel, eine gattungsgemäße Kugellafette zu schaffen, die ohne Umbau für verschiedene Infanteriewaffen geeignet ist und die jeweilige Waffe nicht weiter als unbedingt nötig in den Kampfraum ragen läßt.

Erfindungsgemäß wird das dadurch erreicht, daß der Lafettenteil sich im Inneren des Kugelkörpers befindet und sich mittels eines Anschlagbundes über eine Druckfeder auf einem im Kugelkörper fixierten Druckring abstützt, und daß der Lafettenteil eine innere zylindrische Paßbohrung für die Aufnahme einer die Waffe haltenden und aus der Paßbohrung herausziehbaren Adapterhülse aufweist, für die eine Verriegelungsvorrichtung vorgesehen ist.

Dadurch ist zunächst bei entsprechender Dimensionierung des Kugelkörpers der Lafettenteil in dessen Innerem untergebracht, was den Raumbedarf im Kampfraum erheblich vermindert. Weiters kann dadurch die Handfeuerwaffe viel tiefer in den Kugelkörper hineinragen, was den Raumbedarf weiter vermindert, weil der Schütze beim Richten auch seitwärts weniger Platz braucht. Die Adapterhülse hat immer dieselben Aussenmaße, ihre innere Kontur kann aber der jeweils verwendeten Waffe angepaßt werden. Sie kann von der Waffe abnehmbar gestaltet sein. Die Kosten dafür sind jedenfalls gering, weil die Adapterhülse ein einfaches Drehteil ist.

In einer bevorzugten Ausführungsform der Erfindung die Verriegelungsvorrichtung als quer zur Schußrichtung angeordneter federbelasteter Sperriegel ausgebildet, der mit einer Haltefläche der Adapterhülse zusammenwirkt.

Zum Lösen der Waffe braucht nur das Verriegelungselement geöffnet zu werden, dann kann die Adapterhülse aus dem Lafettenteil gezogen werden, was sehr schnell und einfach geht. Ein derartiges Verriegelungselement zeichnet sich wieder durch geringsten Platzbedarf bei ausreichendem Haltevermögen aus und ist mit einem einfachen Handgriff zu öffnen.

In einer vorteilhaften Weiterbildung der Erfindung besteht die Adapterhülse aus zwei Halbschalen (Anspruch 3). Wenn der Lauf der Waffe irgendeinen Bund aufweist, erübrigt sich so eine Befestigung der Adapterhülse an der Waffe. Wenn sie im Lafettenteil steckt, wird sie von diesem zusammengehalten. Beim Herausziehen der Waffe fallen die beiden Halbschalen einfach ab.

Im Detail kann dann noch vorgesehen sein, daß die beiden Halbschalen gelenkig miteinander verbunden sind (Anspruch 4) und/oder daß die Adapterhülse bzw. deren Teile beweglich mit dem Lafettenteil verbunden sind (Anspruch 5). Auf diese Weise ist sichergestellt, daß die Schützen nach der abgesessenen Arbeit die Adapterhülsenteile nicht suchen müssen.

Im folgenden wird die Erfindungen anhand von Abbildungen beschrieben und erläutert. Es stellen dar:
- Fig.1:: Eine Ansicht der Kugellafette von außen,
- Fig.2:: Einen Schnitt nach II-II in Fig.1, und
- Fig.3:: Eine Detailansicht nach III in Fig.2.

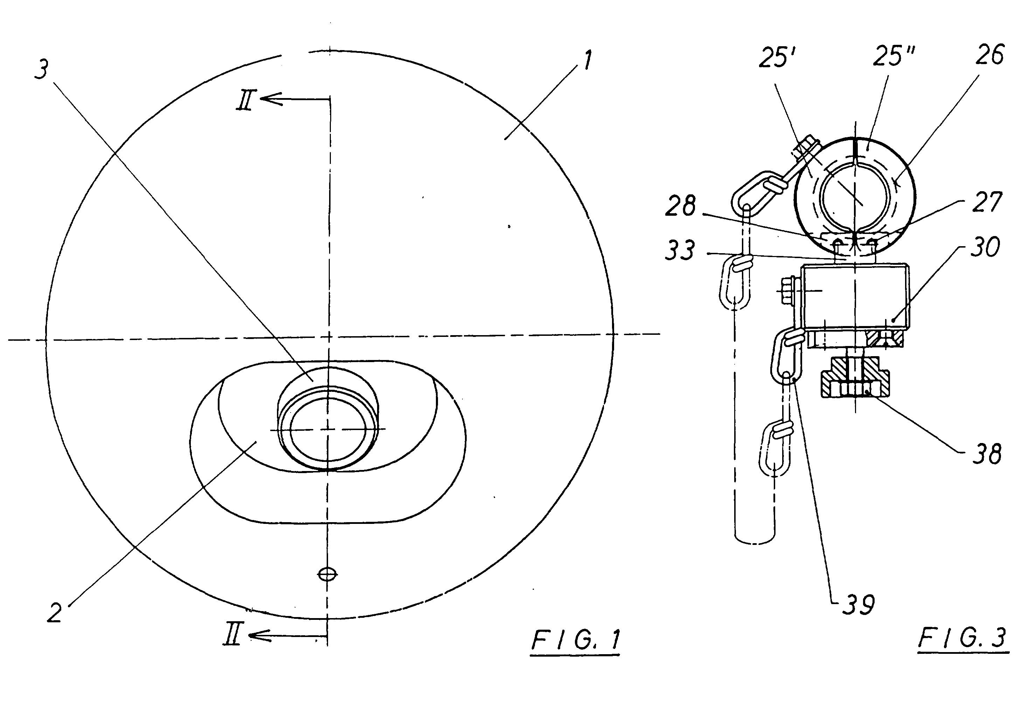

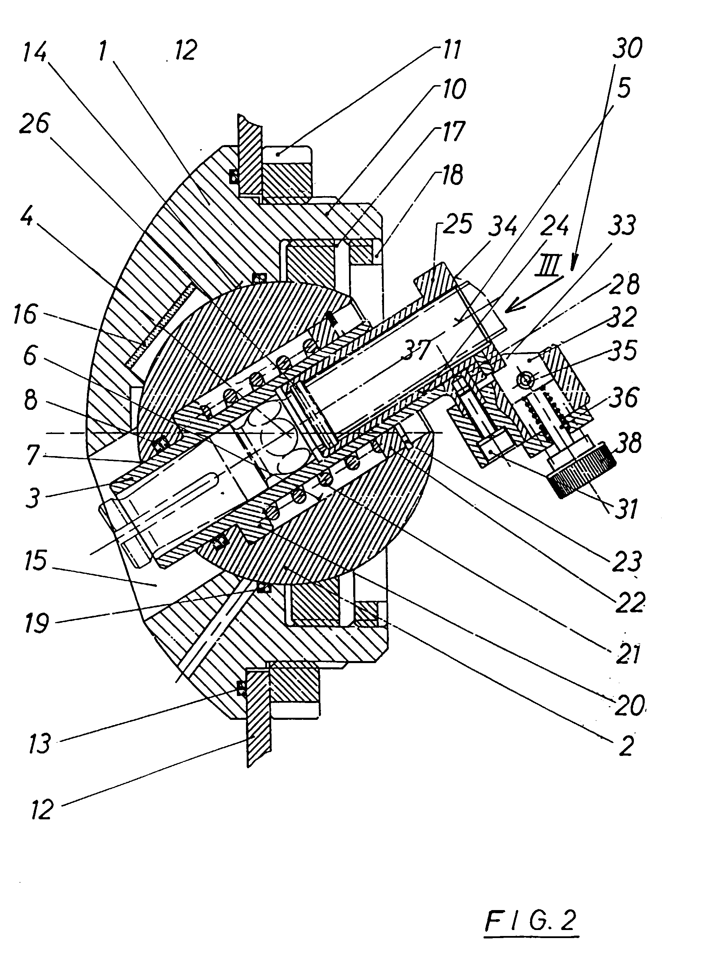

Die in den Figuren 1 und 2 abgebildete Kugellafette besteht aus einer Kugelaufnahme 1, einem Kugelkörper 2 und einem Lafettenteil 3. Mit 4 ist eine Waffe bezeichnet, deren Lauf und Mündung strichliert angedeutet ist, der Rest ist weggelassen. Die Laufachse bzw Schußrichtung ist mit 5 bezeichnet.

Die Kugelaufnahme 1 ist an der Fahrzeugaußenseite konvex gekrümmt, auf der Innenseite weist sie einen Gewindeflansch 10 und eine Mutter 11 auf, die das Panzerblech 12 der Fahrzeug-Außenwand umschließen, wodurch die Kugelaufnahme mit dem Fahrzeug verbunden ist. Mit 13 ist eine Dichtung bezeichnet. Auf der Innenseite ist in der Kugelaufnahme 1 eine halbsphärische Führungsfläche 14 ausgebildet, die durch die Schießluke 15 unterbrochen ist. 16 ist ein Anschlag für den Lafettenteil 3, wenn der Kugelkörper 3 in seine geschlossene Stellung gedreht ist. Der Kugelkörper 2 wird in der Kugelaufnahme 1 von einer Führungsmutter 17 mit Kontermutter 18, die außen in den Gewindeflansch 10 eingreifen, festgehalten. Mit 19 ist wieder eine Dichtung bezeichnet.

Im Inneren des Kugelkörpers 2 ist eine große Bohrung 6 vorgesehen, an die nach außen eine kleinere Bohrung 7 anschließt, in der eine Dichtung 8 angebracht ist. Der rohrförmige Lafettenteil 3 befindet sich in diesen beiden Bohrungen 6,7. Er weist einen Anschlagbund 20 auf, der sich über eine Druckfeder 21 auf einem Druckring 22 abstützt, der mit einem Sprengring 23 fixiert ist. Auf der Innenseite des rohrförmigen Lafettenteiles ist eine Paßbohrung 24 eingearbeitet. Der Lafettenteil 3 ist gegen die Kraft der Feder 21 verschiebbar und in der Bohrung 7 einerseits und andererseits in dem Druckring 22 geführt.

Der Lauf der Waffe 4 ist zur Befestigung in der Kugellafette mit einer Adapterhülse 25 versehen, die mit dem Lauf fest verbunden sein kann oder, wie im dargestellten Ausführungsbeispiel, und in Figur 3 besser zu sehen, aus zwei Halbschalen 25',25" bestehen, die einen Bund 26 des Waffenlaufes umschließen und bei in die Kugelaufnahme eingeführter Waffe durch die Paßbohrung 24 zusammengehalten werden. Die beiden Halbschalen 25',25" hängen über Scharnierbolzen 27 und Verbindungsstück 28 zusammen (Figur 3).

Am hinteren Ende des Lafettenteiles 3 ist eine Verriegelungsvorrichtung 30 mittels Schrauben 31 angebracht. In ihr ist ein Sperriegel 32 mit einem Sperrzahn 33 quer zur Schußrichtung 5 verschiebbar geführt. Der Sperriegel 32 ist über ein Gelenk 35 mit einer Zugstange 36 verbunden, an der eine Rändelmutter 38 angreift. Weiters wird der Sperriegel 32 von einer Druckfeder 37 in Schließrichtung belastet, sodaß der Sperrzahn 33 auf eine Haltefläche 34 der Adapterhülse 25 drückt. So wird die Waffe 4 mit Adapterhülse 25 in der Kugellafette festgehalten.

Zum Lösen der Waffe 4 aus der Kugellafette braucht nur an der Rändelmutter 38 gezogen zu werden, dadurch wird die Adapterhülse freigegeben und die Waffe 4 kann mit der Adapterhülse 25 herausgezogen werden. Sobald sie ganz heraußen ist, fallen die beiden Hälften auseinander, wobei sie jedoch von den Scharnierbolzen 27 und dem Verbindungsstück 28 zusammengehalten werden, sie bleiben (Figur 3) an einem Ketterl 39 hängen, das an der Verriegelungsvorrichtung 30 angeschraubt ist. Die Adapterhülse 25 ist somit beweglich mit dem Lafettenteil 3 verbunden. Im Falle einer Waffe mit einteiliger Adapterhülse 25 würde bei Öffnen des Sperriegels 32 die Waffe mitsamt der Adapterhülse herausgezogen werden können.

## Patentansprüche

1. Kugellafette für gepanzerte Fahrzeuge zur Aufnahme von Handfeuerwaffen, bestehend aus einem in einer Kugelaufnahme (1) geführten Kugelkörper (2) und einem gegenüber diesem federnd abgestütztem Lafettenteil (3), dadurch **gekennzeichnet**, daß der Lafettenteil (3) sich im Inneren des Kugelkörpers (2) befindet und sich mittels eines Anschlagbundes (20) über eine Druckfeder (21) auf einem im Kugelkörper (2) fixierten Druckring (22) abstützt, und daß der Lafettenteil (3) eine innere zylindrische Paßbohrung (24) für die Aufnahme einer die Waffe (4) haltenden und aus der Paßbohrung (24) herausziehbaren Adapterhülse (25; 25',25") aufweist, für welche eine Verriegelungsvorrichtung (30) (25; 25',25") vorgesehen ist.

2. Kugellafette nach Anspruch 1, dadurch gekennzeichnet, daß die Verriegelungsvorrichtung (30) (25; 25',25") als quer zur Schußrichtung (5) angeordneter federbelasteter Sperriegel (32) ausgebildet ist, der mit einer Haltefläche (34) der Adapterhülse (25; 25',25") zusammenwirkt.

3. Kugellafette nach Anspruch 1, dadurch gekennzeichnet, daß die Adapterhülse (25) aus zwei Halbschalen (25',25") besteht.

4. Kugellafette nach Anspruch 3, dadurch gekennzeichnet, daß die beiden Halbschalen (25',25") gelenkig miteinander verbunden sind (27,28).

5. Kugellafette nach Anspruch 3, dadurch gekennzeichnet, daß die Adapterhülse (25) bzw. deren Teile (25',25") beweglich mit dem Lafettenteil (3) verbunden sind.

## Claims

1. A spherical mounting for armoured vehicles for retaining portable firearms, comprising a sphere (2) guided in a sphere retainer (1) and a mounting part (3) spring-supported in relation to said sphere (2), characterised in that the mounting part (3) is located in the interior of the sphere (2), via a pressure spring (21) supported on a thrust collar (22) attached to the sphere (2) by means of a limit stop collar (20), and in that the mounting part (3) comprises an inner cylindrical fitting borehole (24) for accommodating an adapter sleeve (25; 25', 25") retaining the weapon (4), said adapter sleeve (25; 25', 25") being able to be withdrawn from said fitting borehole (24), with a locking device (30) (25; 25', 25") being provided for said adapter sleeve.

2. A spherical mounting according to claim 1, characterised in that the locking device (30) (25; 25', 25") is a spring-loaded locking bolt (32) arranged transversely to the direction of firing (5), with said locking device interacting with a holding surface (34) of the adapter sleeve (25; 25', 25").

3. A spherical mounting according to claim 1, characterised in that the adapter sleeve (25) comprises two half-shells (25', 25").

4. A spherical mounting according to claim 3, characterised in that the two half-shells (25', 25") are connected so as to be hinged (27, 28).

5. A spherical mounting according to claim 3, characterised in that the adapter sleeve (25) or its parts (25', 25") are movably connected to the mounting part (3).

## Revendications

1. Affût à rotule pour véhicules blindés destiné à la réception d'armes de poing et comprenant un corps sphérique (2) guidé dans un logement sphérique (1) et une partie d'affût (3) s'appuyant de façon élastique sur ce corps, caractérisé en ce que la partie d'affût (3) se trouve à l'intérieur du corps sphérique (2), s'appuie au moyen d'un collet de butée (20) et par l'intermédiaire d'un ressort à pression (21) sur une bague de serrage (22) fixée dans le corps sphérique (2) et présente un alésage d'ajustage (24) cylindrique intérieur destiné à recevoir un manchon de raccord (25; 25',25") maintenant l'arme (4), pouvant être extrait de l'alésage d'ajustage (24) et pour lequel est prévu un dispositif de verrouillage (30) (25; 25',25'').

2. Affût à rotule selon la revendication 1 caractérisé en ce que le dispositif de verrouillage (30) (25; 25',25'') est conçu comme un verrou de sûreté (32) équilibré par ressort et disposé transversalement à l'axe de tir (5), lequel agit conjointement avec une surface de retenue (34) du manchon de raccord (25; 25',25'').

3. Affût à rotule selon la revendication 1 caractérisé en ce que le manchon de raccord (25) se compose de deux semi-coques (25',25").

4. Affût à rotule selon la revendication 3 caractérisé en ce que les deux semi-coques (25',25") sont reliées articulées entre elles (27, 28).

5. Affût à rotule selon la revendication 3 caractérisé en ce que le manchon de raccord (25) ou ses parties (25',25") sont reliés de façon mobile à la partie d'affût (3).
